Europäisches Patentamt

European Patent Office

Office européen des brevets

(19)

(11) Veröffentlichungsnummer: **0 029 604**
**B1**

(12) **EUROPÄISCHE PATENTSCHRIFT**

(45) Veröffentlichungstag der Patentschrift:
**02.11.83**

(21) Anmeldenummer: **80107293.5**

(22) Anmeldetag: **22.11.80**

(51) Int. Cl.³: **H 01 J 37/302, B 41 C 1/02**

(54) **Elektronenstrahl-Gravierverfahren.**

(30) Priorität: **24.11.79 DE 2947444**

(43) Veröffentlichungstag der Anmeldung:
**03.06.81 Patentblatt 81/22**

(45) Bekanntmachung des Hinweises auf die Patenterteilung:
**02.11.83 Patentblatt 83/44**

(84) Benannte Vertragsstaaten:
**AT BE CH FR GB IT LI NL SE**

(56) Entgegenhaltungen:
**DE - A - 2 458 370**
**DE - B - 1 123 561**
**DE - B - 1 298 851**
**FR - A - 2 410 356**
**US - A - 3 638 231**

(73) Patentinhaber: **DR.-ING. RUDOLF HELL GmbH,**
**Grenzstrasse 1-5, D-2300 Kiel 14 (DE)**

(72) Erfinder: **Beisswenger, Siegfried,**
**Albert-Einstein-Strasse 22, D-2308 Preetz (DE)**
Erfinder: **Boppel, Wolfgang, Waldweg 7A, D-2308 Preetz**
**(DE)**
Erfinder: **Grieger, Dieter, Heiderstrasse 12, D-2300 Kiel**
**(DE)**

## Elektronenstrahl-Gravierverfahren

### Technisches Gebiet

Die vorliegende Erfindung betrifft ein Elektronenstrahl-Gravierverfahren, insbesondere zur Herstellung von Druckformen zur schnell aufeinanderfolgenden Erzeugung von Vertiefungen unterschiedlicher Grösse in der Oberfläche eines Werkstücks, wobei die unterschiedlichen Vertiefungen durch unterschiedliche Einwirkung des Elektronenstrahls erzeugt werden.

### Zugrundeliegender Stand der Technik

In der US-PS 4 028 523 sind ein Energiestrahl-Gravierverfahren und eine Einrichtung zum Durchführen des Verfahrens beschrieben, wobei zur Herstellung einer Tiefdruckform näpfchenförmige Vertiefungen in der Oberfläche eines Werkstücks, in diesem Falle eines Tiefdruckzylinders erzeugt werden. Hierzu wird die Grösse der zu erzeugenden Näpfchen durch kürzere oder längere Einwirkdauer des Elektronenstrahls auf die Werkstoffoberfläche bestimmt. Dies geschieht dadurch, dass der Elektronenstrahl in den Zeiträumen, in denen kein Bearbeitungseffekt auftreten soll, die Werkstoffoberfläche nicht trifft, sondern an geeigneter Stelle innerhalb des Elektronenstrahlerzeugers, seitlich in einem «Sumpf» (Auffänger), abgelenkt wird. Dies erfolgt mittels einer zusätzlichen Ablenkanordnung, die als elektrostatische oder elektromagnetische Ablenkeinrichtung ausgebildet ist (Blankingeffekt).

Die Variation der Näpfchengrösse, d.h. des Näpfchenvolumens, das jeweils ein Mass für die beim Druckprozess von der Druckform übertragende Farbe ist, kann unter Variation der Strahlintensität, der Einsatzdauer und der Strahlfokussierung erfolgen, wobei ein entsprechender Materialabtrag in der Druckformoberfläche stattfindet. Die Fokussierung wird während der Einsatzzeit des Elektronenstrahls so gesteuert, dass die Fokusebene bei kleinen Näpfchen näher an der Oberfläche liegt als bei grossen Näpfchen.

Solche Graviersysteme haben sich aber bis heute in der Praxis nicht durchgesetzt, obschon sie wegen der trägheitslosen Steuerung des Elektronenstrahls an sich eine wesentliche höhere Arbeitsgeschwindigkeit erlauben als Gravierverfahren, die z.B. mittels elektromagnetisch angetriebener Stichel arbeiten oder als das herkömmliche Ätzverfahren.

Eine der Ursachen hierfür ist das schlechte Einlaufverhalten bei Gravurbeginn und in Gravurpausen, was sich dadurch bemerkbar macht, dass sich bei hoher Arbeitsfrequenz, d.h. kurzer Gravierdauer pro Näpfchen und hoher Strahlintensität die Näpfchengeometrie, d.h. Form und Volumen der Näpfchen stark ändert, so dass bei Beginn der Gravur oder auch bei einem späteren Eingravieren in die Druckform falsche Näpfchen graviert werden, wodurch die gesamte Druckform unbrauchbar wird.

Beim Einschalten des Elektronenstrahls bzw. beim Wiedereinschalten und bei der laufenden Ablenkung (Blanking) zwischen der Gravur der einzelnen Näpfchen baut sich durch die Ionisation des Restgases innerhalb des Volumens des Strahlerzeugers eine positive Raumladung auf, die den statischen Fokuszustand des Elektronenstrahls ungünstig beeinflusst, d.h. unkontrollierbar macht. Bis sich ein statischer Zustand eingestellt hat, vergeht eine gewisse Zeit, innerhalb der die vorgenannten Näpfchenverformungen auftreten, was aber für die Herstellung einer einwandfreien Druckform nicht in Kauf genommen werden kann.

Dieser Effekt trat bisher bei Materialbearbeitung mit Elektronenstrahl und bei Elektronenstrahlschweissgeräten nicht störend auf. Bei der Herstellung von Druckformen für die Drucktechnik müssen dagegen feinste Strukturen mit sehr hoher Dynamik erzeugt werden, so dass dieser Effekt stark in negativer Weise hervortritt, da das Auge beim Betrachten eines Druckproduktes auf Fehler, die durch fehlerhafte Druckformen, d.h. fehlerhaft gravierte Näpfchen erzeugt werden, besonders stark reagiert.

### Offenbarung der Erfindung

Der vorliegenden Erfindung liegt daher die Aufgabe zugrunde, diese Nachteile zu vermeiden und ein neues verbessertes Verfahren zur schnellen aufeinanderfolgenden Erzeugung von Vertiefungen oder Löchern innerhalb der Oberfläche eines Werkstücks, insbesondere einer Tiefdruckform anzugeben.

Die Erfindung erreicht dies durch den kennzeichnenden Teil der in den Ansprüchen 1 und 2 angegebenen Merkmale. Vorteilhafte Weiterbildungen der Erfindung sind in den Unteransprüchen 3 und 4 beschrieben.

### Kurze Beschreibung der Erfindung

Die Erfindung wird im folgenden anhand der Figur näher erläutert.

### Bester Weg zur Ausführung der Erfindung

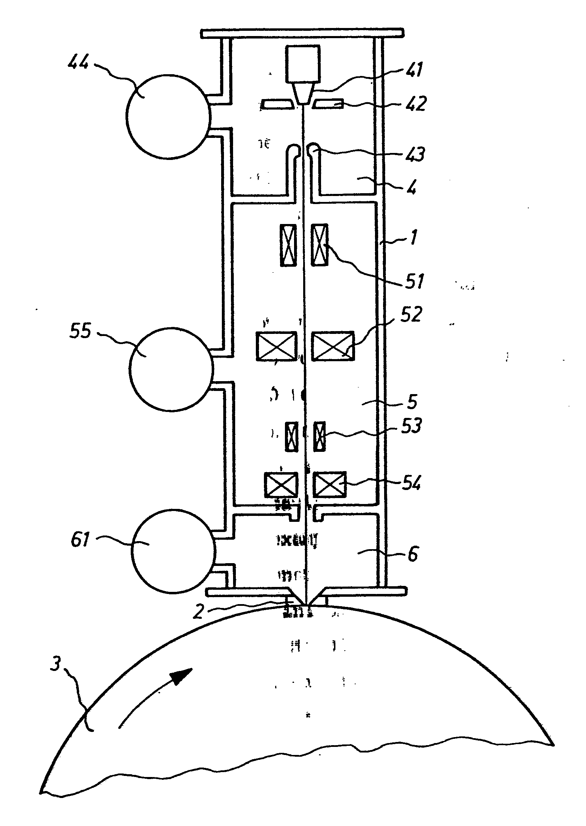

Die Figur zeigt schematisch ein Elektronenstrahlerzeugungssystem, wie es im Prinzip in der US-PS 4 028 523 in Fig. 3 dargestellt ist. Das Elektronenstrahlerzeugungssystem 1 liegt mittels einer gleitenden Spezialdichtung 2 auf einen rotierenden Tiefdruckzylinder 3 auf. Die Spezialdichtung 2 kann z.B. gemäss DE-OS 2 819 993 oder DE-OS 2 834 457 bzw. DE-OS 2 834 458 ausgebildet sein.

Das Elektronenstrahlerzeugungssystem 1 besteht im wesentlichen aus drei Kammern, dem Strahlerzeuger 4, dem Strahlformungs- bzw. -führungsteil 5 und der Bearbeitungskammer 6. Der Strahlerzeuger 4 enthält eine Glühkathode 41, einen Wehneltzylinder 42, eine Anode 43 und eine Vakuumpumpe 44. Das Teil 5 enthält gestrichelt gezeichnet eine Ablenkanordnung 51 mit einem Strahlsumpf 52, der aus einem ringförmigen Metallteil bestehen kann. Während der Pausen zwi-

schen der Gravur der einzelnen Näpfchen wird der Strahl mittels der Ablenkeinheit 51 aus dem Zentrum des Elektronenstrahlerzeugungssystems und damit von der Oberfläche des zu bearbeitenden Werkstücks abgelenkt. Diese Ablenkanordnung mit Strahlfänger, welche ein sogenanntes «Blanking-System» darstellt, kann ebenso ausgebildet sein wie bei der US-PS 4 028 523, aber das System wird anders betrieben. Gemäss der einen Ausführungsform der Erfindung wird der Elektronenstrahl nicht während der gesamten Pause zwischen der Gravur von zwei aufeinanderfolgenden Näpfchen ausgeschaltet, d.h. abgelenkt, sondern er wird mittels des Blanking-Systems in den Gravurpausen mehrfach impulsartig auf die zu bearbeitende Oberfläche gerichtet, damit sich im Verlauf des Strahlengangs keine neue Raumladung aufbaut. Bei genügend häufiger Folge von Einzelimpulsen und bei einer solchen Bemessung der Impulsdauer, dass kein Bearbeitungseffekt auftritt, bleibt der Ionisationszustand innerhalb des Strahlerzeugers und insbesondere in dem Bereich, der für die Fokussierung massgebend ist, unverändert, so dass kein Anlaufeffekt auftritt.

Die Figur zeigt weiterhin in dem Strahlformungsteil eine dynamische Fokusspule 53 und eine statische Fokusspule 54, die während der Gravur der Näpfchen die eingangs beschriebene Fokussierung durchführen. Die Wirkungsweise einer solchen Fokussierung entspricht derjenigen, wie sie in der US-PS 4 028 523 beschrieben ist.

Bei der zweiten Ausführungsform gemäss der Erfindung wird der Elektronenstrahl während der Gravurpausen nicht von der Oberfläche des Druckzylinders abgelenkt, sondern er bleibt auf dieser stehen, wird aber defokussiert. Die Defokussierung erfolgt in dem Masse, dass ebenfalls kein Bearbeitungseffekt auftritt. Die auf die Oberfläche des rotierenden Druckzylinders übertragene Energie wird von diesem aufgenommen und weggeleitet. Dieses dauernde Stehenbleiben des Elektronenstrahls auf der Druckformoberfläche führt ebenfalls dazu, dass der Ionisationszustand innerhalb des Elektronenstrahlerzeugungersystems konstant bleibt und sich keine Raumladung aufbauen kann, wodurch die eingangs genannten Anlaufeffekte ebenfalls vermieden werden.

Eine vorteilhafte Weiterbildung der Erfindung kann darin bestehen, dass die statische und dynamische Fokusspule gemäss DE-OS 2 752 598 ausgebildet sind, bei der die dynamische Linse innerhalb der statischen Linse angeordnet ist. Dies hat den Vorteil, dass man mit wesentlich geringerer Steuerleistung für die dynamische Fokusspule auskommt und dass durch diese spezielle Spulenausbildung eine kürzere Ausbildung des gesamten Elektronenstrahlererzeugersystem möglich ist.

Der Ordnung halber sei noch erwähnt, dass sowohl an dem Strahlformungsteil eine Vakuumpumpe 55 als auch an der Bearbeitungskammer 6 eine separate Vakuumpumpe 61 angeschlossen sind. Dies hat den Vorteil, dass innerhalb der einzelnen Kammern mit für die jeweiligen Belange erforderlichem gestuften Vakuum gearbeitet werden kann und dass die einzelnen Stufen gegebenenfalls voneinander abgetrennt werden können, ohne dass das gesamte System neu evakuiert werden muss.

Wie bereits erwähnt, sind der Betrieb der einzelnen Elektroden und deren Ansteuerung dem Fachmann allgemein bekannt, weshalb nochmals auf die US-PS 4 028 523 verwiesen wird. Speziell für das Anwendungsgebiet der Elektronenstrahlgravur in der Drucktechnik sei noch darauf hingewiesen, dass die Anspannung der dynamischen Fokuslinse tonwertabhängig ist, d.h. von der Näpfchengrösse abhängt. Bei kleinvolumigen Näpfchen werden kurze Fokusimpulse abgegeben, bei grossvolumigen Näpfchen lange Fokusimpulse, was einen Stromsteuerbereich von 0,5 bis etwa 1 Amp. an der dynamischen Fokusspule ausmacht. Bei der Defokussierung in den Gravurpausen wird die dynamische Linse stromlos gemacht. Der Strahldurchmesser auf der Bearbeitungsfläche liegt bei der Gravur etwa bei 100 µm und bei Defokussierung etwa bei 400 µm. Diese Defokussierung reicht wegen der guten Wärmeleitung der Kupferoberfläche der üblichen Kupferdruckzylinder aus, um einen Bearbeitungseffekt innerhalb der Gravurpausen zu vermeiden.

Die vorliegende Erfindung beschränkt sich nicht auf das Gebiet der Herstellung von Tiefdruckzylindern, sondern kann ebenfalls zur Herstellung feiner Strukturen, bei denen es auf äusserste Präzision ankommt, so z.B. bei der Herstellung von modernen Halbleiterbauelementen, bei der Perforation feinster Folien usw. d.h. bei allen Anwendungsgebieten für Elektronenstrahlerzeugungssysteme, bei denen es auf eine schnelle Elektronenstrahlschuss-Folgefrequenz ankommt und der eingangs beschriebene negative Effekt vermieden werden soll.

## Patentansprüche

1. Elektronenstrahl-Gravierverfahren zur schnellen aufeinanderfolgenden Erzeugung von Vertiefungen unterschiedlicher Grösse in der Oberfläche eines Werkstücks, wobei die unterschiedlichen Vertiefungen durch unterschiedliche Einwirkung des Elektronenstrahls erzeugt werden, dadurch gekennzeichnet, dass der Elektronenstrahl in den Pausen zwischen der Erzeugung der einzelnen Vertiefungen eingeschaltet auf dem Werkstück steht und so defokussiert ist, dass kein Bearbeitungseffekt auftritt.

2. Elektronenstrahl-Gravierverfahren zur schnellen aufeinanderfolgenden Erzeugung von Vertiefungen unterschiedlicher Grösse in der Oberfläche eines Werkstücks, wobei die unterschiedlichen Vertiefungen durch unterschiedliche Einwirkung des Elektronenstrahls erzeugt werden, dadurch gekennzeichnet, dass in den Pausen zwischen der Erzeugung der Vertiefungen der Energiestrahl in kurzen Impulsen auf die Oberfläche des Werkstücks gerichtet wird, wobei die Impulsdauer so kurz ist, dass kein Bearbeitungseffekt auftritt.

3. Verfahren nach Anspruch 2, dadurch gekennzeichnet, dass die impulsartige Steuerung des Elektronenstrahls mittels einer Ablenkschaltung erfolgt.

4. Verfahren nach Anspruch 1 oder 2, dadurch gekennzeichnet, dass die Fokussierung bzw. Defokussierung mit einer Linsenanordnung durchgeführt wird, bei der die dynamische Linse innerhalb der statischen Linse angeordnet ist.

## Claims

1. A method of electron beam engraving for the rapid successive production of recesses of varying size in the surface of a workpiece, the different recesses being produced by different application of the electron beam, characterised in that during the intervals between generating the separate recesses, the electron beam remains switched on and incident on the workpiece and is defocussed in such manner that no working action occurs.

2. A method of electron beam engraving for the rapid successive production of recesses of varying size in the surface of a workpiece, the different recesses being produced by different application of the electron beam, characterised in that during the intervals between generating the separate recesses, the electron beam is directed against the surface of the workpiece in brief pulses, the pulse duration being so short that no working action occurs.

3. A method according to claim 2, characterised in that the pulsed operation of the electron beam is performed by means of a time-base circuit.

4. A method according to claim 1 or 2, characterised in that the focussing and defocussing actions are performed by means of a lens system in which the dynamic lens is situated within the static lens.

## Revendications

1. Procédé de gravure par un faisceau d'électrons pour créer suivant une succession rapide des cavités de dimensions différentes, dans la surface d'une pièce, les cavités différentes étant créées par une action différente du faisceau d'électrons, caractérisé en ce que dans les pauses entre la réalisation des différentes cavités, le faisceau des électrons reste branché sur la pièce et est défocalisé de façon qu'il n'y ait pas d'effet d'usinage.

2. Procédé de gravure par un faisceau d'électrons pour créer en succession rapide des cavités de dimensions différentes dans la surface d'une pièce, les cavités différentes étant créées par l'action différente du faisceau d'électrons, caractérisé en ce que dans les pauses entre la réalisation des cavités le faisceau d'énergie est dirigé en courtes impulsions sur la surface de la pièce, la durée d'impulsion étant suffisamment courte pour qu'il n'y ait pas d'effet d'usinage.

3. Procédé selon la revendication 2, caractérisé en ce que la commande impulsionnelle du faisceau d'électrons se fait à l'aide d'un circuit déflecteur.

4. Procédé selon les revendications 1 ou 2, caractérisé en ce que la focalisation ou la défocalisation se fait à l'aide d'un montage en lentille et la lentille dynamique est prévue à l'intérieur de la lentille statique.